# EUROPEAN PATENT SPECIFICATION

(11) **EP 2 478 067 B1**
(45) Date of publication and mention of the grant of the patent: **24.06.2015**
(21) Application number: 10766246.2
(22) Date of filing: 17.09.2010
(51) Int. Cl.: C09K 11/06, C08G 61/12, C09B 69/10, C09B 57/10, H01L 51/50

(54) **ELECTROLUMINESCENT MATERIALS AND DEVICES**
ELEKTROLUMINESZIERENDE MATERIALIEN UND VORRICHTUNGEN
MATIÈRES ÉLECTROLUMINESCENTES ET DISPOSITIFS CORRESPONDANTS

(30) Priority: 18.09.2009 GB 0916395
(43) Date of publication of application: 25.07.2012
(60) Divisional application: 12190102.9
(73) Proprietor: Thorn Lighting Limited, Spennymoor, Durham DL16 6HL (GB)
(72) Inventor: WILLIAMS, Geoff, Spennymoor, Durham DL16 6HL (GB); MONKMAN, Andrew P., South Road, Durham DH1 3LE (GB); BRYCE, Martin R., Richmond, North Yorkshire DL11 7NW (GB); LYONS, Ben P., South Road, Durham DH1 3LE (GB); VAUGHAN, Helen L., South Road, Durham DH1 3LE (GB); KAMTEKAR, Kiran T., Bromsgrowe B61 0DW (GB)
(74) Representative: Thun, Clemens
(86) International application number: PCT/EP2010/063721
(87) International publication number: WO 2011/033078

(56) References cited:
- WO-A1-2007/132236
- DATABASE WPI Week 200502 Thomson Scientific, London, GB; AN 2005-014204 XP002610379, -& CN 1 528 760 A (UNIV SHANGHAI JIAOTONG) 15 September 2004 (2004-09-15)
- PEREPICHKA I I ET AL: "Dibenzothiophene-S,S-dioxide-fluorene co-oligomers. Stable highly-efficient blue emitters with improved electron affinity", CHEMICAL COMMUNICATIONS - CHEMCOM, ROYAL SOCIETY OF CHEMISTRY, GB, 9 June 2005 (2005-06-09), pages 3397-3399, XP002451407, ISSN: 1359-7345, DOI: DOI:10.1039/B417717G
- KING S M ET AL: "Exploiting a dual-fluorescence process in fluorene-dibenzothiophene-S ,S-dioxide co-polymers to give efficient single polymer LEDs with broadened emission", ADVANCED FUNCTIONAL MATERIALS, WILEY - V C H VERLAG GMBH & CO. KGAA, DE, vol. 19, no. 4, 24 February 2009 (2009-02-24), pages 586-591, XP001520269, ISSN: 1616-301X, DOI: DOI:10.1002/ADFM.200801237

## Description

The present invention relates to electroluminescent materials and devices.

Electroluminescence is a phenomenon whereby materials emit light in response to an electric current passed therethrough. This phenomenon is exploited, *inter alia*, in the manufacture and operation of organic light emitting diodes (OLEDs). OLEDs typically include an organic semiconducting material which comprises an organic small molecule and/or a polymer (e.g. an oligomer).

In a simple OLED configuration, a thin film comprising an organic light emitting material is sandwiched between an anode and a cathode. When a bias voltage is applied across the device, holes are injected into the highest occupied molecular orbital (HOMO) of the light emitting material and electrons are injected into the lowest unoccupied molecular orbital (LUMO). When the electrons and holes recombine, an exciton is formed which is able to decay radiatively, resulting in the emission of light. The colour of the light produced is dependent on the HOMO- LUMO bandgap of the material.

However, in order to improve stability and enhance device efficiency (photons of light emitted per injected charge) a multi-layered device is usually employed. Such devices incorporate layers of charge transporting material such as an electron transport material and/or a hole transporting material to affect the injection of charges into the light emitting material resulting in enhanced light emission. A number of materials have been described for use as electron and hole transporting materials (Kulkarni et al. Chem. Mater. 2004, 16: 4556 - 4573; Yan et al . Appl. Phys. Lett. 2004, 84: 3873 - 3875).

White organic light emitting devices (WOLEDs) have attracted increasing interest in recent years as their potential applications to full colour displays with the help of colour filters, in backlights for liquid crystal displays (LCDs) and in solid-state lighting (SSL) devices become apparent. Consequently, an efficient single-component OLED capable of white light emission is highly desirable.

A number of approaches have been described for achieving white emission from WOLEDs, such as using multi-layer device structures to get white light emission at the same time from two or more active layers which each emit a different colour light (Burrows et al. Appl . Phys. Lett. 1998, 73: 435 - 437; D'Andrade et al . Adv. Mater. 2002, 14: 147 - 151; Lee et al . Mater. Sci. Eng. , B, 2002, 95:24 - 28; Huang et al . Appl. Phys. Lett. 2002, 80: 2782 - 2784), devices comprising single-layers into which different fluorescent or phosphorescent dopants are dispersed into a host polymer (where a dopant is an impurity element added in low concentrations to alter the optical/electrical properties of a semiconductor material) (Kido et al. Appl. Phys. Lett. 1995, 67; 2281 - 2283; Mazzeo et al . , Synth Met. 2003, 139:675 - 677) or pixelated structures in which the three Red, Green and Blue active layers are patterned as a matrix array using precise shadow masking (Kido et al. Appl. Phys. Lett. 1995, 67; 2281 - 2283). However, the high band gap required for blue emissions has ensured that the production of efficient, long-lasting blue emitters has proved challenging.

WO 2007/132236 A1 discloses electroluminescent polymers, their synthesis and their use in optical devices. WO 2007/132236 A1 thereby discusses a number of approaches that have been described for achieving white emission from WOLEDs, such as using multi-layer device structures to get white light emission at the same time from two or more active layers which each emit a different colour light (Burrows et al. Appl . Phys. Lett. 1998, 73: 435 - 437; D'Andrade et al . Adv. Mater. 2002, 14: 147 - 151; Lee et al . Mater. Sci. Eng. , B, 2002, 95:24 - 28; Huang et al . Appl. Phys. Lett. 2002, 80: 2782 - 2784), devices comprising single-layers into which different fluorescent or phosphorescent dopants are dispersed into a host polymer (where a dopant is an impurity element added in low concentrations to alter the optical/electrical properties of a semi-conductor material) (Kido et al. Appl. Phys. Lett. 1995, 67; 2281 - 2283; Mazzeo et al . , Synth Met. 2003, 139:675 - 677) or pixelated structures in which the three Red, Green and Blue active layers are patterned as a matrix array using precise shadow masking (Kido et al. Appl. Phys. Lett. 1995, 67; 2281 - 2283). D1 provides in this context fluorene based copolymers or co-oligomers of (I) Dibenzothiophene-S,S-dioxide and (II) fluorene.

A single layer structure WOLED is desirable since they lend themselves more readily to large scale production and low-cost manufacturing. However, the single layer fluorescent or phosphorescent doped WOLEDs that have been described above suffer from a number of drawbacks including variations in the CIE (Commission Internationale de l'Eclairage) co-ordinates of colour emission depending upon the applied bias voltage, rendering them less preferable for LCD backlight and other illumination purposes.

Over the last decade polyfluorenes (PF) have emerged as effective electroluminescent materials in the class of semiconductive organic conjugated polymers. Properties of PFs which render them suitable for electroluminescent applications include bright blue emission, high hole mobility, excellent thermal and chemical/electrochemical stability and easy tuneable properties through chemical modifications and co-polymerisations. However, the mobility and injection of electrons are much lower than that of holes in these materials, resulting in a greatly unbalanced transport of positive and negative carriers. This poor charge balance in the electroluminescent material leads to overall low efficiency of OLED devices based on PFs. A further problem inherent to PF materials is the formation of fluorene defects as a result of thermal-, photo-, or electrical degradation, which is frequently encountered in these materials, resulting in low emission bands.

Many different approaches have been used to mitigate these problems; among them is the introduction of either electron donor or electron acceptor moieties into the homopolymers (in the backbone, as side-chains or endcaps). In OLEDs, the introduction of such electron donor or electron deficient moieties represents an efficient way to modify the HOMO-LUMO levels of the polymers thus allowing improved electron/hole mobility of the material, decreased barriers of charge injection into the electroluminescent layer, and tuning of the colour emission, i.e. by reducing the LUMO energy at the interface of the electrode and the polymer it is possible to increase electron injection to balance the charges in the device and improve efficiency.

PFs, and indeed other conjugated polymer systems, may be synthesised by a number of methods, but are commonly made by one of the Suzuki polymerisation method or the Yamamoto polymerisation method. Each of these methods ensures a coupling of the conjugation systems of the monomer units.

Suzuki polymerisation effects the coupling of an aryl- or vinyl-boronic acid or ester with an aryl or vinyl halide to form a conjugated system. The reaction is catalysed by a palladium (0) complex such as tetrakis(triphenylphosphine)palladium(0) and is described in several review papers (such as Suzuki, A. J. Organometallic Chem. 1999, 576, 147-168).

Its use in polymerisation for organic semiconductors is described in Sakamoto J. et al., Macrol. Rapid Commun., 2009, 30, 653-687.

Yamamoto polymerisation effects the coupling of aryl- or vinyl-magnesium halides with aryl- or vinyl-halides to form a conjugated system. The reaction is catalysed by nickel complexes and was first described by Yamamoto et al in Bull Chem. Soc. Jpn., 1978, 51, 2091. Its use in polymerisation for organic semiconductors is described in Yamamoto T. Prog. Polym. Sci., 1993, 17, 1153-1205.

Fluorene-based copolymers incorporating electron-deficient thiophene-S, S-dioxide moieties have been tested and did not demonstrate improved performance of LED over conventional PF homopolymers, showing low to moderate external EL efficiencies of 10⁻³ to 0.14% (Charas et al . Chem. Commun. 2001, 1216: Charas et al., J. Mater. Chem. 2002, 12:3523; Pasini et al., J. Mater. Chem. 2003, 13:807; Destri et al., Synth. Metals, 2003, 138, 289). Therefore, typically it is not expected that incorporation of a thiophene-S,S-dioxide moiety into a fluorene-based copolymer would be beneficial. In fact it is expected, and reported, that quenching of the emission occurs resulting in overall poor efficiency of OLED devices incorporating these materials.

Regular and random fluorene copolymers containing dibenzothiophene-2, 8-diyl (Yang et al. J. Mater. Chem. 2003, 13:1351 - 1356; Nemoto et al. J. Polym. Sex. A:Polym. Chem. 2003, 41:1521 - 1526) and PPV copolymers containing dibenzothiophene-S, S-dioxide-2, 8-diyl (Wang et al. Thin Solid Films 2003, 424:186 - 190; Wang et al . Synth. Metals 2003, 132:191 - 195) moieties in the main chain have been reported, which again showed from moderate to very low efficiency in OLED.

Again, these results would indicate that fluorene-based copolymers incorporating thiophene-S,S-dioxide units as conjugated polymers would lead to poor efficiencies in OLED.

In a first aspect, the invention provides an electroluminescent polymer according to claim 1 comprising a first repeat unit comprising the structure: 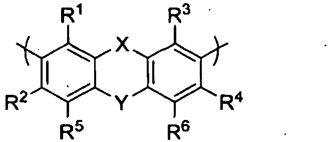 where R¹ to R⁶ are the same or different and comprise H or optionally substituted C₁ to C₂₆ straight or branched alkyl, alkenyl or alkynyl chains, alkoxy group; and wherein at least one of R¹ and R² and at least one of R³ and R⁴ is not H, where X is SO₂ and where Y is not present.

Without wishing to be bound by any particular theory, the inventors have found that the inclusion of at least one substituent group at R¹ or R² and at least one substituent group at R³ or R⁴ provides sufficient steric effect to twist the first repeat unit with respect to the remainder of the polymer backbone. It is proposed that this twisting may cause a drop in the conjugation and increases the band gap of the material, thereby offering a deep blue emission spectrum.

Moreover, the inventors have surprisingly found that upon the inclusion of at least one substituent group at R¹ or R² and at least one substituent group or R³ or R⁴, an increase in emission efficiency is observed.

When referring to para-coupling and meta-coupling the ring structures are numbered such that carbon 1 is the carbon next to the atom or group of atoms with greatest molecular weight. Position 2 is "ortho", position 3 is "meta", and position 4 is "para".

Preferably R⁵ and/or R⁶ are H.

Preferably, at least three (e.g. all) of R¹ to R⁴ are not H.

Preferably, R¹ to R⁴, if not H, comprise C₁ to C₁₀ straight or branched alkyl alkenyl or alkynyl chains.

Preferably, the first repeat unit comprises the structure: 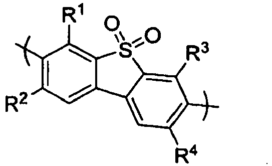 where in particular R¹ and R³ are H and R² and R⁴ are C₆H₁₃.

Preferably, the polymer comprises a second repeat unit comprising an organic semiconducting moiety.

Preferably, the second repeat unit comprises the structure: 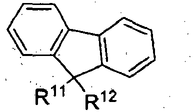 where Roland R¹² are the same or different and may comprise H or an optionally substituted C₁ to C₂₀ straight, branched or cyclic alkyl, alkenyl or alkynyl chain, aryl group, alkoxy group, amino, amido or hydroxyl groups.

Preferably, R¹¹ and R¹² are both C₈H₁₇.

It was also found that the presence of the first repeat units considerably increases the solubility of the electroluminescent polymer which facilitates better solution processing, such as spin-coating and thus represents an important advantage. Further, also the formation of electroluminescent polymers having a high content of the first repeat unit is possible.

Accordingly, the ratio of the number y of the first repeat units to the number x of the second repeat units is preferably at least 15:85, more preferably 30:70 and in particular 50:50.

Preferably, R⁴ and R⁵ comprise C₁ to C₁₀ unsubstituted straight alkyl chains.

Preferably, the second repeat unit is incorporated into the polymer backbone by para-coupling or meta-coupling.

According to a further aspect of the invention there is provided a fluorene-based copolymer or oligomer comprising one or more first repeat units comprising the structure:

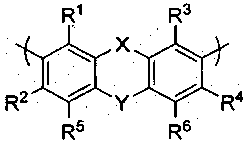

Optionally, the copolymer or oligomer according to the first or second aspects further comprises at least one alkyne group. The at least one alkyne group can be situated between a first repeat unit and a second repeat unit or between two second repeat units.

In certain embodiments, the polymer may comprise a third repeat unit 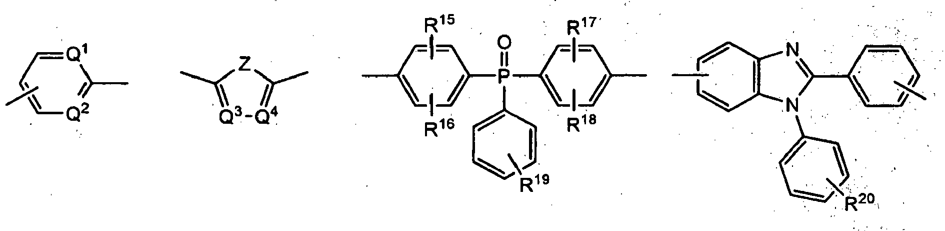 comprising an electron transport moiety. The electron transport moiety preferably comprises a structure selected from the group:
where R¹⁵ to R²⁰ may be the same or different and may comprise H or C₁ to C₁₀ (e.g. C₁ or C₅) optionally substituted, straight, branched or cyclic alkyl, alkenyl or alkynyl groups, nitro, amino, amido, halo, alkoxy, hydroxyl, thiol or thioalkyl; where Q¹ to Q⁴ may be the same or different and may comprise N or CH and where Z may comprise O, NR or S.

Preferably, the polymer comprises a fourth different repeat unit comprising a hole transport moiety.

Preferably, the hole transport moiety preferably comprises a structure selected from the group: 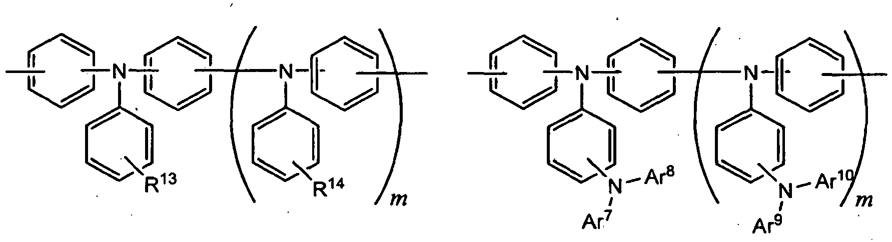 where R¹³ and R¹⁴ may be the same or different and may comprise H or C₁ to C₁₀ (e.g. C₁ or C₅) optionally substituted, straight, branched or cyclic alkyl, alkenyl or alkynyl groups, nitro, amino, amido, halo, alkoxy, hydroxyl, thiol or thioalkyl and where Ar⁷ to Ar¹⁰ comprise optionally substituted aryl groups.

Preferably, the polymer comprises a block copolymer, regular or alternating copolymer or a random copolymer, including the first repeat unit and one, some or all of the second, third and fourth repeat units.

Preferably, the copolymer is a random copolymer. The term "random copolymer" denotes a copolymer consisting of macromolecules in which the probability of finding a given monomeric unit at any given site in the chain is independent of the nature of the adjacent units.

The term "regular copolymer" denotes a copolymer comprising a sequence of regularly alternating repeating units.

The term "block copolymer" denotes a copolymer where each repeat unit is arranged to be adjacent at least one identical repeat unit.

In some embodiments the polymer further comprises one or more red and/or green emitting repeat units. Preferably the red and/or green emitting repeat units comprise phosphorescent emitters, such as those selected from complexes of the form IrL₃ or IrL₂X, where 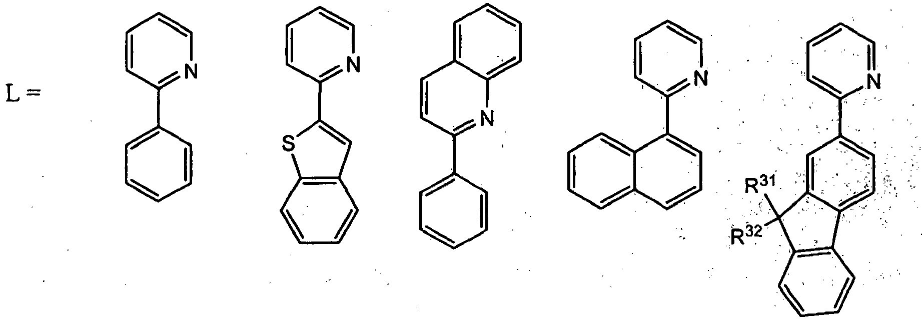 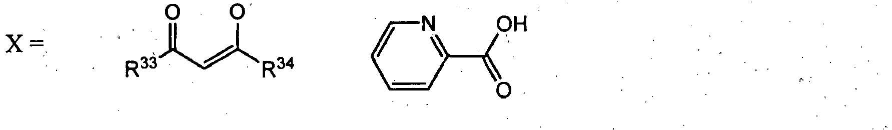 where R³¹ to R³⁴ may be the same or different and may comprise H or C₁ to C₁₀ (e.g. C₁ or C₅) optionally substituted, straight, branched or cyclic alkyl, alkenyl or alkynyl groups, nitro, amino, amido, halo, alkoxy, hydroxyl, thiol or thioalkyl; or complexes of the form:

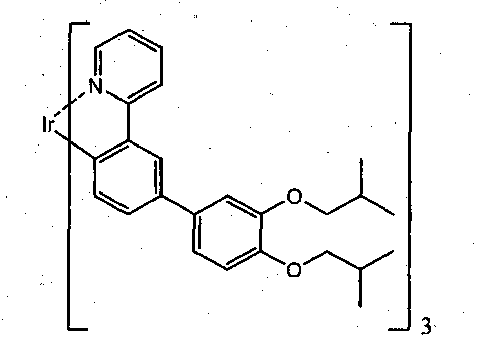

Alternatively or additionally, the polymer may comprise colour dopants, such as those selected from the group: 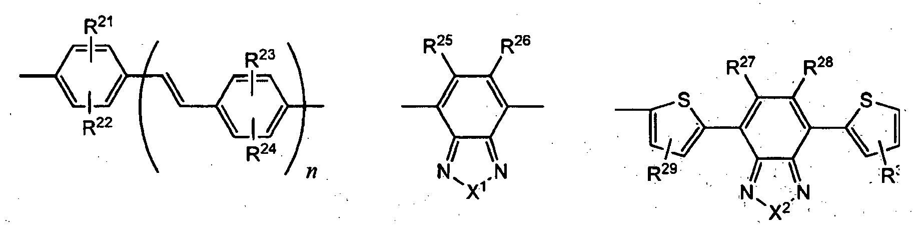 where R²¹ and R³⁰ may be the same or different and may comprise H or C₁ to C₁₀ (*e.g.* C₁ or C₅) optionally substituted, straight, branched or cyclic alkyl, alkenyl or alkynyl groups, nitro, amino, amido, halo, alkoxy, hydroxyl, thiol or thioalkyl and where X¹ and X² may comprise S or C₂H₄.

Optionally, the copolymer or oligomer according to the first or second aspects further comprises at least one alkyne group. The at least one alkyne group can be situated between a first repeat unit and a second repeat unit or between two second repeat units.

Preferably, the optionally first repeat units comprise approximately 2 - 50 mole percent of the polymer.

More preferably, the first repeat units comprise approximately 10 - 35 mole percent of the polymer.

More preferably, the first repeat units comprise approximately 20 - 30 mole percent of the polymer.

Preferably, at least a portion of the first repeat units functions as a blue emitting moiety.

Preferably, at least a portion of the first repeat units functions as an electron transporting moiety.

Preferably, at least a portion of the first repeat units functions as a high energy triplet host in the presence of one or more phosphorescent emitters (e.g. if the polymer comprises or is co-deposited with one or more phosphorescent emitters).

The first repeat units and the second repeat units are preferably selected such that they allow charge transfer therebetween in the excited state.

Preferably, the polymer is capable of emitting light close to white point as determined in the CIE (x,y = 0.33, 0.33).

The second repeat units may be substituted at any suitable position with any suitable functional group which results in a functionally equivalent molecule according to the present invention.

Preferably, when the second repeat units are substituted, they may be substituted at any suitable position with alkyl groups.

Optionally, when the second repeat units are substituted, they may be substituted at any suitable position by pendent moieties.

Optionally, when the second repeat units are substituted, they may be substituted at any suitable position by spiro units.

According to a third aspect of the invention there is provided an optical device comprising a polymer as described above.

Another important result found by the inventors is that the triplet energy of the inventive electroluminescent polymer increases as the percentage of the first repeat unit increases. It is in particular possible to from a polymer which has sufficiently high triplet energy to host, e.g., a green phosphorescent iridium guest emitter.

Accordingly, in a preferred embodiment of the present invention, the optical device additionally comprises a red and/or green phosphorescent emitter.

Preferably, the optical device is an organic light emitting device whereby the polymer makes up at least part of an emissive layer.

Preferably, the organic light emitting device comprises first and second electrodes and the emissive layer is formed between the first and second electrodes.

Optionally, the organic light emitting device comprises at least one further layer, *e.g.* a hole injection layer or an electron injection layer.

Preferably, the copolymers of the invention are prepared by Suzuki polymerisation.

Optionally, the copolymers of the invention can be prepared by any suitable polymerization method, such as Yamomoto polymerization.

The inventors have advantageously established that simple OLED devices incorporating fluorene-based copolymers containing substituted dibenzothiophene-S,S-dioxide demonstrate improved electron transport and light emission over previously reported PF homopolymer devices resulting in improved external quantum efficiencies. The substituted dibenzothiophene-S,S-dioxide moiety also acts as an electron transporting moiety and in combination with the fluorene copolymer functions as a light emission moiety.

This is surprising as whilst thiophene dioxides are known as electron transport materials, heteroatoms are known not to be highly emissive due to quenching of the excited states. Therefore it would not be expected that the incorporation of substituted dibenzothiophene-S,S-dioxide into a fluorene-based copolymer would be highly emissive.

Accordingly, by virtue of this invention, the market for an alternative substantially white light source can be at least partially satisfied by a device comprising a light emitting surface incorporating a fluorene-based copolymer incorporating dibenzothiophene-S,S-dioxide units as described in the first or second aspects above.

As already mentioned above, a further advantage of the present invention derives from the increased solubility of the first repeat group afforded by the one or more substitutions. This facilitates better solution processing, such as spin-coating, of the polymer and thus allows a cost efficient production of OLED devices.

Embodiments of the present invention shall now be described in more detail with reference to the following drawings.
Figure 1 shows a synthesis of a monomer for forming a polymer according to the present invention;
Figure 2 shows a synthesis of a polymer according to the present invention;
Figure 3 shows photoluminescence data for the Polymer 1;
Figure 4 shows photoluminescence data for the Polymer 2;
Figure 5 shows readings for brightness against current density for a device according to Example 3;
Figure 6 shows readings for electroluminescent power against electroluminescent wavelength for a device according to Example 3;
Figure 7 shows current density against voltage for a device according to Example 3;
Figure 8 shows readings for brightness against current density for a device according to Example 4;
Figure 9 shows current density against voltage for a device according to Example 4;
Figure 10 shows readings for electroluminescent intensity against electroluminescent wavelength for a device according to Example 4 and a device according to Example 5;
Figure 11 shows readings for brightness against current density for a device according to Example 5;
Figure 12 shows current density against voltage for a device according to Example 5;
Figure 13 shows electroluminescence spectra from three different inventive devices;
Figure 14 shows corresponding photoluminescence measurements of the three devices.

Random fluorene-dibenzothiophene-S, S-dioxide copolymers were synthesised by palladium-catalyzed Suzuki cross- coupling copolymerisation of 9, 9-dioctylfluorene comonomers and substituted dibromodibenzothiophene-S,S-dioxides as demonstrated in the examples below.

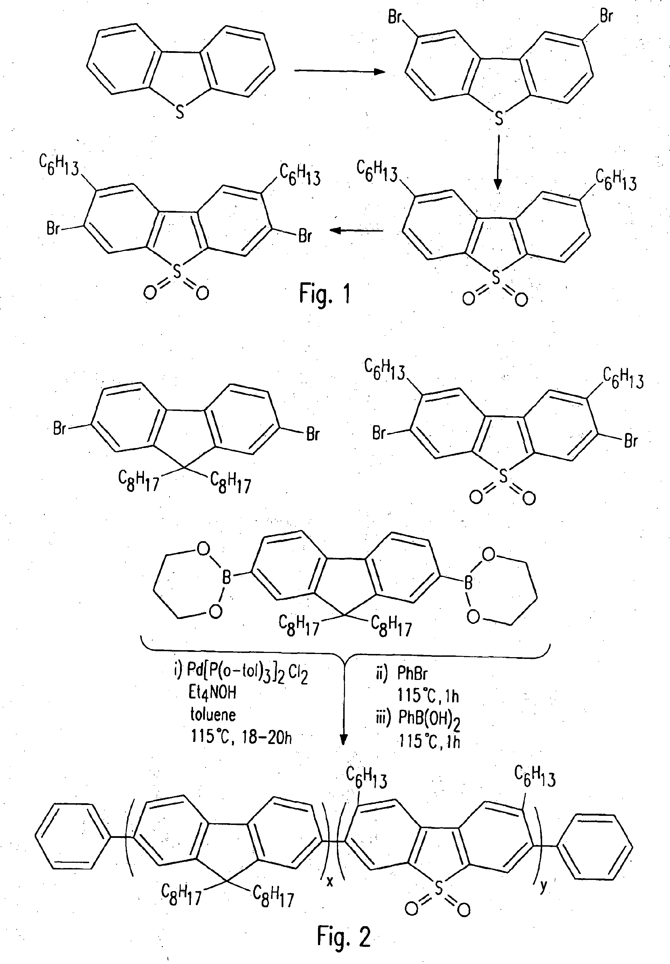

### Preparation of Monomer 1 (see Figure 1)

### Stage 1:

Dibenzothiophene (Aldrich or Alfa Aesar) (195 mmol) was dissolved in a 1:1 mixture of chloroform and acetic acid (both Fisher) (total 400 ml) under a protective atmosphere of argon and cooled in an ice bath. Bromine (Aldrich) (468 mol) in chloroform (25 ml) was added dropwise and the mixture was stirred overnight slowly rising to room temperature. The mixture was poured into methanol (Fisher) (500 ml) to precipitate the dibromodibenzothiophene product which was filtered and washed with methanol.

### Stage 2:

The dibromodibenzothiophene (29.3 mmol) was dissolved in tetrahydrofuran (THF) (Fisher) (200 ml) under a protective atmosphere of argon and cooled in a dry ice/acetone bath. n-Hexyllithium (Aldrich) (64.4 mmol) was added slowly and the solution was stirred for 3 h. Bromohexane (Aldrich) (71.2 mmol) was added and the solution was allowed to warm to room temperature. overnight. The aqueous layer was extracted with diethyl ether (Fisher) and the combined organics were washed with water, dried, filtered and concentrated to yield an oil which was dissolved in acetic acid (Fisher) (50 ml). Hydrogen peroxide (Aldrich) (15 ml) was carefully.added and the solution stirred at 140 °C for 2 h before a further 10 ml of peroxide was added and the solution was stirred at 140 °C overnight. Cooling water was added and the aqueous layer was extracted with chloroform. The organics were washed with water, dried, filtered and concentrated to yield an oil which was dissolved in ethanol. The flask was placed in the freezer overnight to crystallise the sulfone product.

### Stage 3:

The sulfone (13 mmol) was dissolved in H₂SO₄ (Fisher) (300 ml) and heated to 70 °C with protection from light. N-bromosuccinimide (NBS) (Aldrich) (29 mmol) was added in portions and the mixture stirred at 70 °C overnight. Analysis showed the presence of both monobromo and dibromo products so a further portion of NBS (5.6 mmol) was added and stirring continued overnight. Cooling water was added and the aqueous layer was extracted with chloroform and the organics were washed with water, dried, filtered and concentrated to yield an oil which was purified on silica eluting with DCM (Fisher):Petroleum ether 40-60 (Fisher) 1:1. The resulting solid was crystallised from ethanol.

### Example 1

### Synthesis of 70% fluorene - 30% Monomer 1 copolymer "Polymer 1" (Represented graphically in Figure 2).

A flask was charged with 9,9-dioctylfluorene-2,7-diboronic acid bis(1,3-propanediol) ester (400.0 mg, 99.50%, 0.713 mmol), 2,7-dibromo-9,9-dioctylfluorene (157.6 mg, 99.95%, 0.287 mmol), 3,7-dibromo-2,8-dihexyldibenzothiophene-S,S-dioxode (235.0 mg, 98.7%, 0.428 mmol) and toluene (16 m). The mixture was degassed for 15 min before bis[(tri-ortho-tolyl)phosphine]palladiumdichloride (11 mg, 1 mol%) was added and degassing continued for 15 min before a degassed 20% wt. solution of tetraethylammonium hydroxide in water (4 ml) was added and the mixture was vigorously stirred at 115°C with protection from light for 18 h.

Bromobenzene (0.1 ml) was added and stirring continued at 115°C for 1 h before benzeneboronic acid (100 mg) was added and stirring continued at 115°C for 1 h. After cooling, the grey mixture was added slowly to 300 ml of methanol to precipitate the crude polymer as grey fibres. The fibres were filtered and washed with methanol, water and more methanol.

The polymer was redissolved in toluene (20 ml) and a solution of N,N-diethyldithiocarbamic acid sodium salt (15 ml) was added and the mixture was stirred at 65°C for 16 h. The layers were separated and the aqueous layer was extracted with toluene. The combined organic layers were washed with dilute HCl solution, sodium acetate solution and twice with water before being passed through a celite 545 plug to yield a clear yellow solution. The solution was concentrated until it became viscous and was then added dropwise to methanol (350 ml) to precipitate the polymer as off-white fibres which were isolated by filtration and washed with methanol and acetone, 420 mg. Gel permeation chromatography against polystyrene showed an Mₙ of 11,191 and an M_{w} of 29,849.

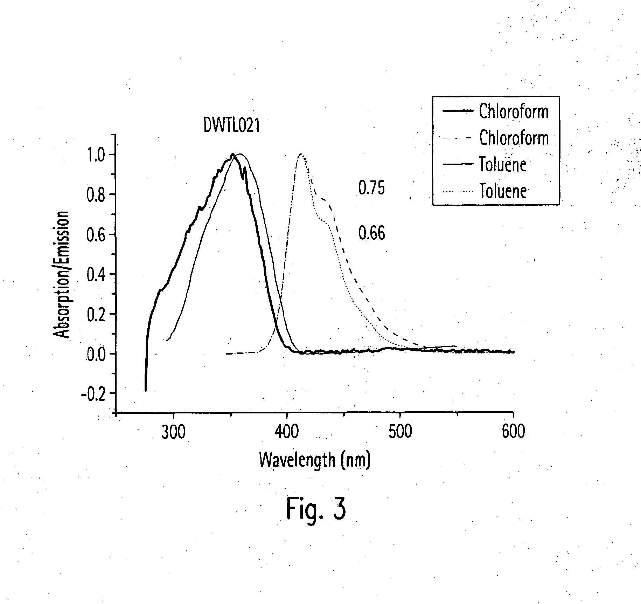

Photoluminescence of Polymer 1 was measured in a fluorometer in solution in toluene and in chloroform (emission peaks at around 410 nm).The results are displayed graphically in Figure 3.

As will be shown in the following, the increased solubility due to alkylation of monomer 1 also enables the synthesis of copolymers with a higher content of dibenzothiophene-S,S-dioxide-3,7-diyl units than is the case for conventional copolymers.

### Example 2

### Synthesis of 50% fluorene - 50% Monomer 2 copolymer "Polymer 2" (Represented graphically in Figure 2).

A flask was charged with 9,9-dioctylfluorene-2,7-diboronic acid bis(1,3-propanediol) ester (400.0 mg, 99.50%, 0.713 mmol) and 3,7-dibromo-2,8-dihexyldibenzothiophene-S,S-dioxode (391.4 mg, 98.7%, 0.713 mmol) and toluene (16 m). The mixture was degassed for 15 min before bis[(tri-ortho-tolyl)phosphine]palladiumdichloride (11 mg, 1 mol%) was added and degassing continued for 15 min before a degassed 20% wt. solution of tetraethylammonium hydroxide in water (4 ml) was added and the mixture was vigorously stirred at 115°C with protection from light for 18 h. Bromobenzene (0.1 ml) was added and stirring continued at 115°C for 1 h before benzeneboronic acid (100 mg) was added and stirring continued at 115°C for 1 h. After cooling, the grey mixture was added slowly to 300 ml of methanol to precipitate the crude polymer as grey fibres. The fibres were filtered and washed with methanol, water and more methanol.

The polymer was redissolved in toluene (20 ml) and a solution of N,N-diethyldithiocarbamic acid sodium salt (15 ml) was added and the mixture was stirred at 65°C for 16 h. The layers were separated and the aqueous layer was extracted with toluene. The combined organic layers were washed with dilute HCl solution, sodium acetate solution and twice with water before being passed through a celite 545 plug to yield a clear yellow solution. The solution was concentrated until it became viscous and was then added dropwise to methanol (350 ml) to precipitate the polymer as off-white fibres which were isolated by filtration and washed with methanol and acetone, 503 mg. Gel permeation chromatography against polystyrene showed an Mₙ of 6,597 and an M_{w} of 14,791.

The increased solubiltiy of monomer 1 thus allowed to formation of an alternating copolymer where each dioctylfluorene unit is adjoined by two dihexyldibenzothiophene-S,S-dioxide-3,7-diyl units.

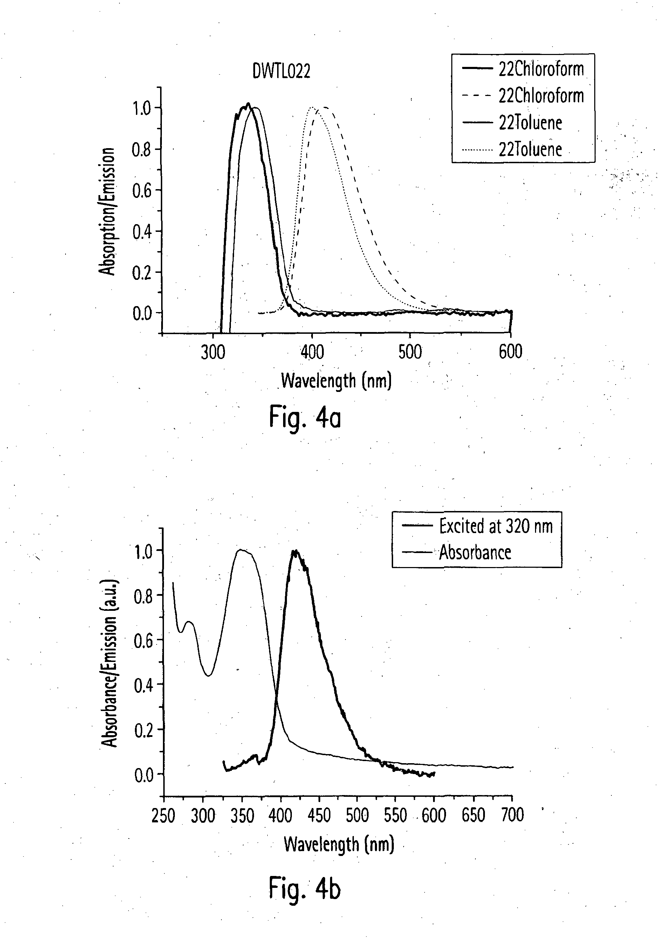

Photoluminescence of Polymer 2 was measured in a fluorometer in solution in toluene and in chloroform (emission peaks at around 410 nm and 415 nm respectively) and as a thin film on a quartz substrate, excited at 320 nm (emission at around 425 nm). The results are displayed graphically in Figures 4a (solution) and 4b (film).

The increased solubiltiy of monomer 1 also increases the solubility of the whole electroluminescent polymer which facilitates better solution processing, such as spin-coating and thus represents an important advantage. The formation of OLED devises is therefore significantly improved.

Electronic devices were fabricated using Polymer 1 and Polymer 2.

### Example 3

An electroluminescent device was fabricated using a 1.1nm thick glass substrate coated with patterned indium tin oxide to give a sheet resistance of 15ohm/sq. The substrate was cleaned with detergent, deionized water, acetone and isopropanol successively in an ultrasonic bath, followed by UV ozone treatment for 10 minutes.

An approximately 50nm-thick layer of poly(3,4-ethylenedioxythiophene) poly(styrenesulfonate) (PEDOT) was spin coated first and then dried for 10 minutes on a hot-plate at 150°C. Polymer 1 was dissolved in toluene and spincoated onto the PEDOT layer to give a layer approximately 65nm thick. A 4nm thick layer of barium and then at least 100nm of aluminium were evaporated through a mask onto the polymer layer in a vacuum of approximately 1x10⁻⁶ mBar.

Four devices of 4mm x 5mm were obtained on a single substrate. The devices were sealed by using a UV curable epoxy resin to fix a piece of glass over the device area.

### Example 4

The method of Example 3 was repeated, replacing Polymer 1 with Polymer 2, to give four devices of 4mm x 5mm on a single substrate.

### Example 5

The method of Example 4 was repeated, however Polymer 2 was co-deposited with 10 w/w% of a green phosphorescent iridium complex as shown below, to give four devices of 4mm x 5mm on a single substrate.

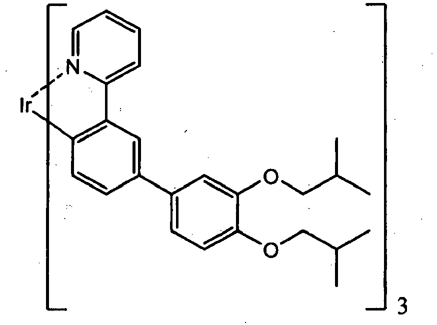

### Device Testing

The substrates of Examples 3, 4 and 5 were each placed in a sample holder where pins made electrical contact to the ITO anodes and barium/aluminium cathodes. The sample holder was mounted in an integrating sphere. The individual devices on each substrate could be selected via switches on the sample holder.

An Agilent 6632B power supply was used to drive the devices. Electroluminescence was measured using an Ocean Optics USB4000 CCD connected to the sphere with a fibre optic cable. The power supply and CCD were both controlled by a personal computer.

The voltage applied to the device was increased in uniform steps and the current and electroluminescence spectrum measured at each step. These values were then used to calculate quantities such as current density, external quantum efficiency, optical power output, wall plug efficiency, luminance, luminous efficacy, brightness and CIE co-ordinates.

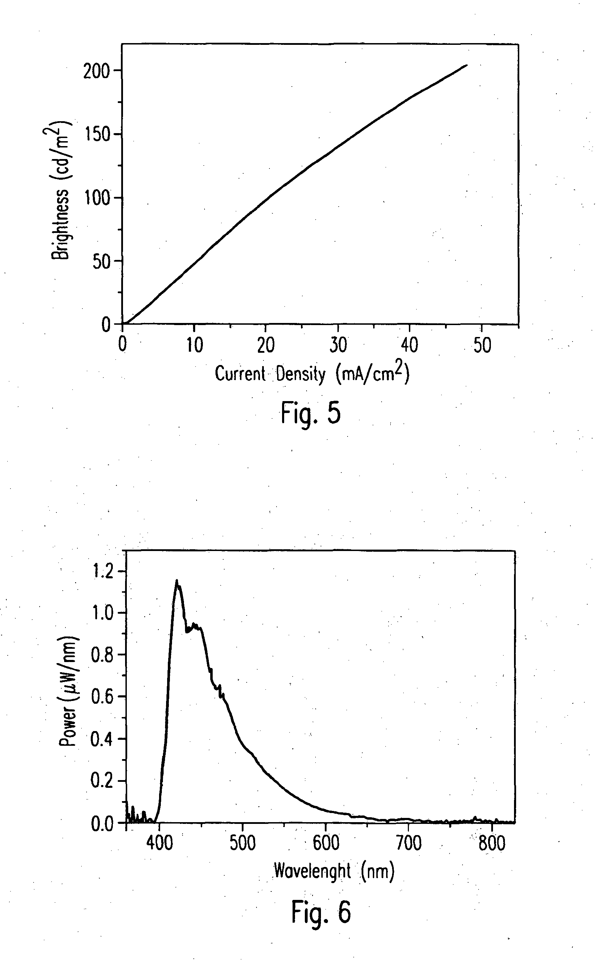

The results of some of these tests are shown in Figures 6 to 11.

As Figures 5 to 7 demonstrate, the device of Example 3 (containing Polymer 1) offers a powerful peak electroluminescent emission at around 425 nm (measured at 7V, 48mA/cm², 202cd/m²), thereby giving a very deep blue emission, without detrimental effect on the device's on-voltage or brightness.

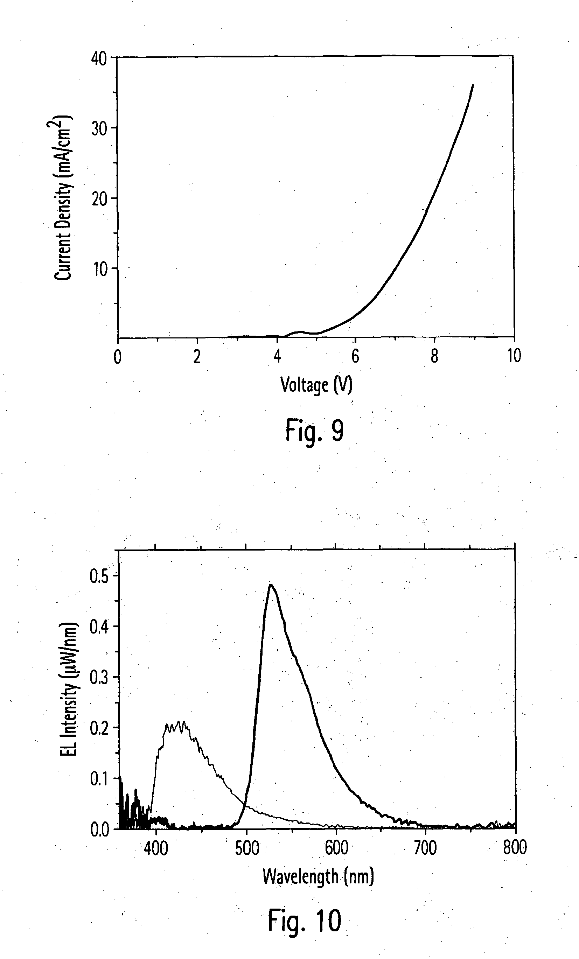

Figure 10 shows overlaid electroluminescent output of devices according to Examples 4 and 5, with Polymer 2 acting as a blue emitter at 425 nm (and with CIE coordinates 0.18, 0.15) in Example 4 (at 7V, 6.4mA/cm², 23cd/m²) and as a high energy triplet host in Example 5, which emits at around 530 nm (at 8V, 6.7mA/cm², 283cd/m² and with CIE coordinates 0.35, 0.62). The phosphorescent nature of the iridium complex provides higher quantum efficiencies and additionally shifts the emission from blue to green, where the human eye is more sensitive. In this way, an extremely efficient OLED device emitting green light is obtained.

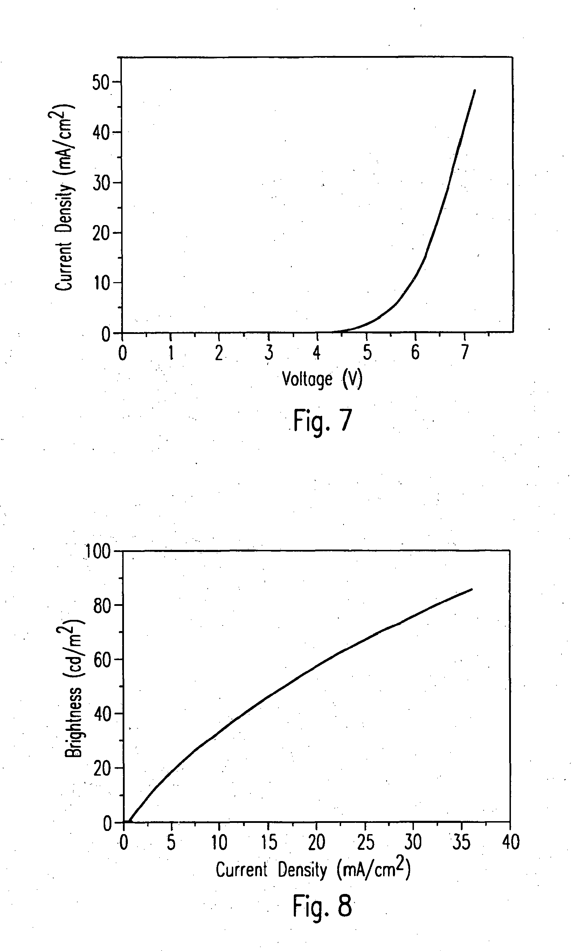

Figures 8 and 9, which display data for the device of Example 4 (containing Polymer 2), show that the device operates well within accepted ranges of voltages.

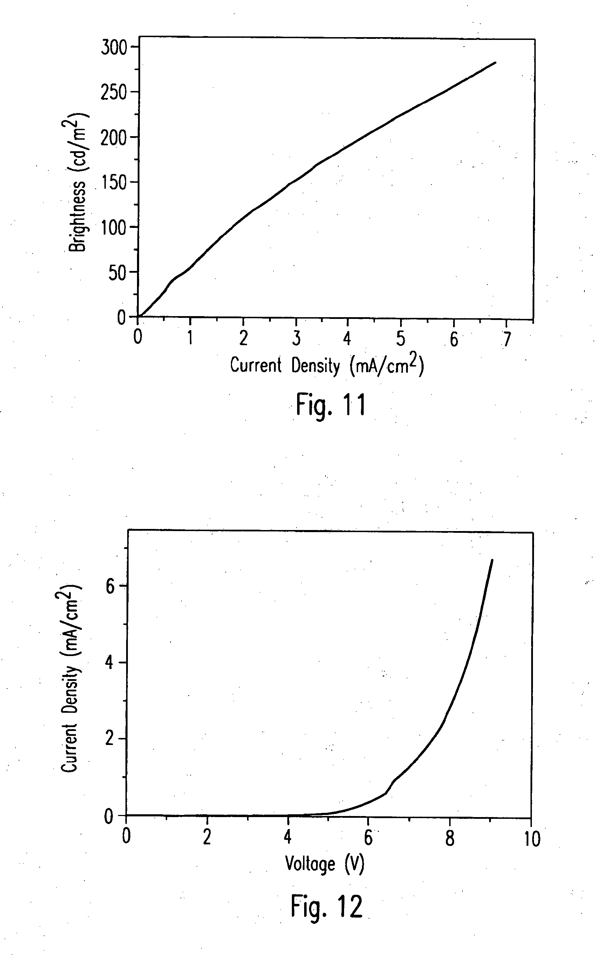

Figures 11 and 12, which display data for the device of Example 5 (containing Polymer 2 and the iridium complex), show that the device also operates well within accepted ranges of voltages.

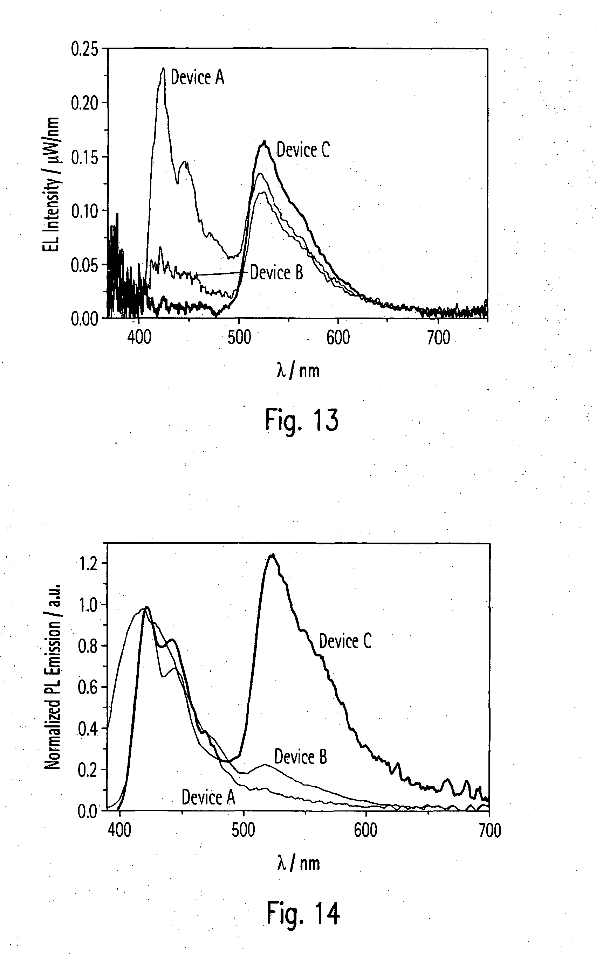

The suitability of the inventive copolymers for hosting green phosphorescent materials results from the fact that the triplet energy of these new copolymers increases as the percentage of the dihexyldibenzothiophene-S,S-dioxide-3,7-diyl units increases. This can be seen from Figures 13 and 14 which show electroluminescence spectra and photoluminescence measurements from three different devices A, B and C with the following structures: glass/ITO (150 nm)/PEDOT:PSS (50 nm)/LEP/Ba (4 nm)/Al (100 nm), wherein in the polymer of Device A the percentage of monomer 1 is 15%, Device B comprises the Polymer 1 of Example 1 (the percentage of monomer 1 being 30%) and Device C comprises the Polymer 2 of Example 2 (the percentage of monomer 1 being 50%), each polymer being blended with 3% of said green phosphorescent iridium complex.

The ratio of green to blue emission is reduced in the photoluminescence measurements relative to the EL measurements. Indeed, blue fluorescence from the host polymer is observed from all the materials, whereas in EL measurements emission from the material of Device C is absent. This provides evidence that under electrical operation excitons are formed on the green phosphorescent iridium complex by direct charge trapping. Although a so-called Dexter energy transfer of triplet excitons cannot be ruled out, this would not reduce the fluorescence from the host polymer.

If the triplet energy of the green phosphorescent iridium complex (or any other phosphorescent guest material) is higher than that of the host polymer, then green emission from the phosphorescent guest will be reduced. Dexter transfer to the phosphorescent complex will be unlikely, and any excitons forming on the phosphorescent complex by direct charge trapping may transfer to the lower energy triplet on the host polymer. In this series of devices A, B and C, emission from the phosphorescent guest becomes more intense as the amount of monomer 1 in the host polymer increases. It is clear that the higher triplet energy is preventing energy transfer to the host. The results show thus convincingly that these polymers can serve as hosts for phosphorescent materials. In particular, the triplet energy of Polymer 2 is sufficiently high enough to serve as a host for green phosphorescent materials.

No doubt many other effective alternatives will occur to the skilled person. It will be understood that the invention is not limited to the described embodiments and encompasses modifications apparent to those skilled in the art lying within the scope of the claims appended hereto.

## Claims

1. An electroluminescent polymer comprising a first repeat unit comprising the structure: 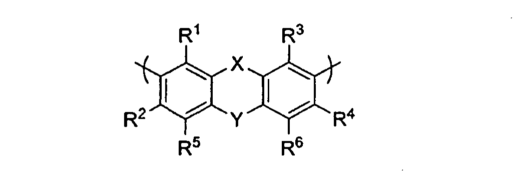 where R¹ to R⁶ are the same or different and comprise H or optionally substituted C₁ to C₂₆ straight or branched alkyl, alkenyl or alkynyl chains, alkoxy group; and wherein at least one of R¹ and R² and at least one of R³ and R⁴ is not H, where X is SO₂ and where Y is not present.

2. An electroluminescent polymer according to Claim 1, wherein R⁵ and/or R⁶ are H.

3. An electroluminescent polymer according to any of Claims 1 or 2, wherein at least three of R¹ to R⁴ are not H.

4. An electroluminescent polymer according to any preceding Claim, wherein R¹ to R⁴, if not H, comprise C₁ to C₁₀ straight or branched alkyl alkenyl or alkynyl chains.

5. An electroluminescent polymer according to any preceding Claim, wherein the first repeat unit comprises the structure: 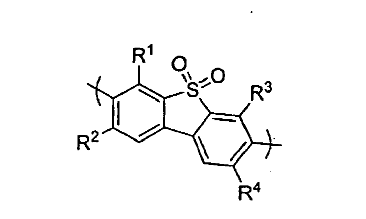 where preferably R¹ and R³ are H and R² and R⁴ are C₆H₁₃·

6. An electroluminescent polymer according to any preceding Claim, wherein the polymer comprises a second repeat unit comprising an organic semiconducting moiety, and wherein the second repeat unit preferably comprises the structure: 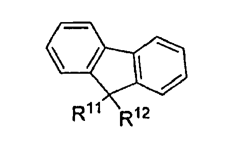 where R¹¹ and R¹² are the same or different and may comprise H or an optionally substituted C₁ to C₂₀ straight, branched or cyclic alkyl, alkenyl or alkynyl chain, aryl group, alkoxy group, amino, amido or hydroxyl groups,
R¹¹ and R¹² being in particular C₈H₁₇.

7. An electroluminescent polymer according to Claim 6, wherein the ratio of the number (y) of the first repeat units to the number (x) of the second repeat units is at least 15:85, preferably 30:70 and in particular 50:50.

8. An electroluminescent polymer according to Claim 6 or 7, wherein R⁴ and R⁵ comprise C₁ to C₁₀ unsubstituted straight alkyl chains.

9. An electroluminescent polymer according to any of Claims 6 to 8, wherein the second repeat unit is incorporated into the polymer backbone by para-coupling or meta-coupling.

10. An electroluminescent polymer according to any preceding Claim, further comprising at least one alkyne group,
wherein the at least one alkyne group preferably can be situated between a first repeat unit and a second repeat unit or between two second repeat units.

11. An electroluminescent polymer according to any preceding Claim, wherein the polymer comprises a third repeat unit comprising an electron transport moiety,
and wherein preferably the polymer comprises a fourth different repeat unit comprising a hole transport moiety.

12. An electroluminescent polymer according to any preceding Claim, wherein the polymer comprises a block copolymer, regular or alternating copolymer or a random copolymer.

13. An electroluminescent polymer according to any preceding Claim, further comprising one or more red and/or green emitting repeat units,
wherein the red and/or green emitting repeat units preferably comprise phosphorescent emitters.

14. An electroluminescent polymer according to any preceding Claim, wherein first repeat units comprise approximately 2 - 50 mole percent of the polymer, e.g. 10 - 35 mole percent or 20 - 30 mole percent of the polymer.

15. An electroluminescent polymer according to any preceding Claim, wherein at least a portion of the first repeat units functions as a blue emitting moiety.

16. An electroluminescent polymer according to any preceding Claim, wherein at least a portion of the first repeat units functions as an electron transporting moiety.

17. An electroluminescent polymer according to any preceding Claim, wherein at least a portion of the first repeat units functions as a high energy triplet host in the presence of one or more phosphorescent emitters, e.g. if the polymer comprises one or more phosphorescent emitters.

18. An electroluminescent polymer according to any preceding Claim, wherein the first repeat units and the second repeat units are selected such that they allow charge transfer therebetween in the excited state.

19. An electroluminescent polymer according to any preceding Claim, wherein the polymer is capable of emitting light close to white point (x,y = 0.33, 0.33).

20. An optical device comprising a polymer according to any preceding Claim, said optical device preferably comprising a red and/or green phosphorescent emitter.

## Patentansprüche

1. Elektrolumineszierendes Polymer, umfassend eine erste Wiederholungseinheit, umfassend die Struktur: 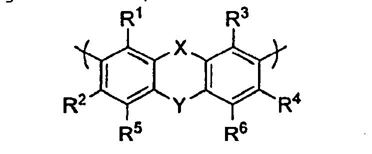 wobei R¹ bis R⁶ gleich oder unterschiedlich sind und H oder optional substituierte C₁- bis C₂₆ gerade oder verzweigte Alkyl-, Alkenyl- oder Alkynylketten, Alkoxygruppe umfassen, und wobei mindestens entweder R¹ oder R² und mindestens entweder R³ und R⁴ nicht H sind, wobei X SO₂ und wobei Y nicht vorhanden ist.

2. Elektrolumineszierendes Polymer nach Anspruch 1, wobei R⁵ und/oder R⁶ H sind.

3. Elektrolumineszierendes Polymer nach einem der Ansprüche 1 oder 2, wobei mindestens drei R¹ bis R⁴ nicht H sind.

4. Elektrolumineszierendes Polymer nach einem der vorhergehenden Ansprüche, wobei R¹ bis R⁴, wenn sie nicht H, C₁-bis C₁₀ gerade oder verzweigte Alkyl-, Alkenyl- oder Alkynylketten umfassen.

5. Elektrolumineszierendes Polymer nach einem der vorhergehenden Ansprüche, wobei die erste Wiederholungseinheit die Struktur umfasst: 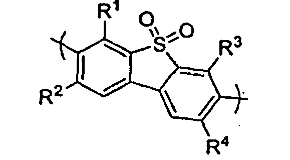 wobei vorzugsweise R¹ und R³ H sind und R² und R⁴ C₆H₁₃ sind.

6. Elektrolumineszierendes Polymer nach einem der vorhergehenden Ansprüche, wobei das Polymer eine zweite Wiederholungseinheit umfasst, umfassend einen organischen halbleitenden Anteil, und wobei die zweite Wiederholungseinheit vorzugsweise die Struktur umfasst: 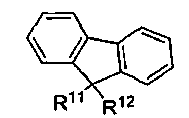 wobei R¹¹ und R¹² gleich oder unterschiedlich sind und H oder eine optional substituierte C₁-bis C₂₀ gerade, verzweigte oder zyklische Alkyl-, Alkenyl- oder Alkynylkette, Arylgruppe, Alkoxygruppe, Amino-, Amido-oder Hydroxylgruppen umfassen können,
wobei R11 und R₁₂ insbesondere C₈H₁₇ sind.

7. Elektrolumineszierendes Polymer nach Anspruch 6, wobei das Verhältnis der Zahl (y) der ersten Wiederholungseinheiten zur Zahl (x) der zweiten Wiederholungseinheiten mindestens 15:85, vorzugsweise 30:70 und insbesondere 50:50 ist.

8. Elektrolumineszierendes Polymer nach Anspruch 6 oder 7, wobei R⁴ und R⁵ unsubstituierte gerade C₁- bis C₁₀-Alkylketten umfassen.

9. Elektrolumineszierendes Polymer nach einem der Ansprüche 6 bis 8, wobei die zweite Wiederholungseinheit in das Polymerrückgrat durch para-Kopplung oder meta-Kopplung integriert ist.

10. Elektrolumineszierendes Polymer nach einem der vorhergehenden Ansprüche, ferner umfassend mindestens eine Alkyngruppe,
wobei die mindestens eine Alkyngruppe vorzugsweise zwischen einer ersten Wiederholungseinheit und einer zweiten Wiederholungseinheit oder zwischen zwei Wiederholungseinheiten angeordnet sein kann.

11. Elektrolumineszierendes Polymer nach einem der vorhergehenden Ansprüche, wobei das Polymer eine dritte Wiederholungseinheit umfasst, umfassend einen Elektronentransportanteil,
und wobei das Polymer vorzugsweise eine vierte unterschiedliche Wiederholungseinheit umfasst, umfassend einen Lochleitungsanteil.

12. Elektrolumineszierendes Polymer nach einem der vorhergehenden Ansprüche, wobei das Polymer ein BlockCopolymer, ein reguläres oder alternierendes Copolymer oder ein statistisches Copolymer umfasst.

13. Elektrolumineszierendes Polymer nach einem der vorhergehenden Ansprüche, ferner umfassend eine oder mehrere rote und/oder grüne emittierende Wiederholungseinheiten,
wobei die roten und/oder grünen emittierenden Wiederholungseinheiten vorzugsweise phosphoreszierende Emitter umfassen.

14. Elektrolumineszierendes Polymer nach einem der vorhergehenden Ansprüche, wobei die ersten Wiederholungseinheiten ungefähr 2 bis 50 Molprozent des Polymers, z. B. 10 bis 35 Molprozent oder 20 bis 30 Molprozent des Polymers umfassen.

15. Elektrolumineszierendes Polymer nach einem der vorhergehenden Ansprüche, wobei mindestens ein Abschnitt der ersten Wiederholungseinheiten als blau emittierender Anteil funktioniert.

16. Elektrolumineszierendes Polymer nach einem der vorhergehenden Ansprüche, wobei mindestens ein Abschnitt der ersten Wiederholungseinheiten als Elektronentransportanteil funktioniert.

17. Elektrolumineszierendes Polymer nach einem der vorhergehenden Ansprüche, wobei mindestens ein Abschnitt der ersten Wiederholungseinheiten als Host mit hoher Triplett-Energie bei Vorhandensein von einem oder mehreren phosphoreszierenden Emittern funktioniert, z. B. wenn das Polymer einen oder mehrere phosphoreszierende Emitter umfasst.

18. Elektrolumineszierendes Polymer nach einem der vorhergehenden Ansprüche, wobei die ersten Wiederholungseinheiten und die zweiten Wiederholungseinheiten ausgewählt werden, sodass sie den Ladungstransfer dazwischen im erregten Zustand erlauben.

19. Elektrolumineszierendes Polymer nach einem der vorhergehenden Ansprüche, wobei das Polymer in der Lage ist, Licht nahe am Weißpunkt (y, y = 0,33, 0,33) zu emittieren.

20. Optische Vorrichtung, umfassend ein Polymer nach einem der vorhergehenden Ansprüche, wobei diese optische Vorrichtung vorzugsweise einen roten und/oder grünen phosphoreszierenden Emitter umfasst.

## Revendications

1. Polymère électroluminescent comprenant une première unité de répétition comprenant la structure : 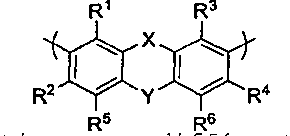 où R¹ à R⁶ sont identiques ou différents et comprennent H ou des chaînes alkyl, alkenyle ou alkynyle, ramifiées ou droites, un groupe alkoxy éventuellement substitués en C₁ à C₂₆ ; et dans lequel au moins l'un de R¹ et R² et au moins l'un de R3 et R4 n'est pas H, où X est SO₂ et où Y n'est pas présent.

2. Polymère électroluminescent selon la revendication 1, dans lequel R⁵ et/ou R⁶ sont H.

3. Polymère électroluminescent selon l'une quelconque des revendications 1 ou 2, dans lequel au moins trois des R¹ à R⁴ ne sont pas H.

4. Polymère électroluminescent selon l'une quelconque des revendications précédentes, dans lequel R¹ à R⁴, s'ils ne sont pas H, comprennent des chaînes alkyl, alkenyle ou alkynyle droites ou ramifiées en C₁ à C₁₀.

5. Polymère électroluminescent selon l'une quelconque des revendications précédentes, dans lequel la première unité de répétition comprend la structure : 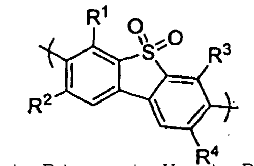 où de préférence R¹ et R³ sont H et R² et R⁴ sont C₆H₁₃.

6. Polymère électroluminescent selon l'une quelconque des revendications précédentes, dans lequel le polymère comprend une seconde unité de répétition comprenant un groupe caractéristique semi-conducteur organique, et dans lequel la seconde unité de répétition comprend de préférence la structure : 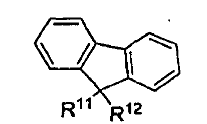 où R¹¹ et R¹² sont identiques ou différents et peuvent comprendre H ou une chaîne alkyl, alkenyle ou alkynyle droite, ramifiée ou cyclique, un groupe aryle, un groupe alkoxy, des groupes amino, amido ou hydroxyle éventuellement substitués en C₁ à C₂₀,
R₁₁ et R₁₂ étant en particulier C₈H₁₇.

7. Polymère électroluminescent selon la revendication 6, dans lequel le rapport entre le nombre (y) des premières unités de répétition et le nombre (x) des secondes unités de répétition est au moins de 15:85, de préférence 30:70 et en particulier de 50:50.

8. Polymère électroluminescent selon les revendications 6 ou 7, dans lequel R⁴ et R⁵ comprennent des chaînes alkyle droites non substituées en C₁ à C₁₀.

9. Polymère électroluminescent selon l'une quelconque des revendications de 6 à 8, dans lequel la seconde unité de répétition est incorporée dans la chaîne principale du polymère par copulation en para ou en méta.

10. Polymère électroluminescent selon l'une quelconque des revendications précédentes, comprenant de plus au moins un groupe alcyne,
dans lequel l'au moins un groupe alcyne peut, de préférence, être situé entre une première unité de répétition et une seconde unité de répétition ou entre deux secondes unités de répétition.

11. Polymère électroluminescent selon l'une quelconque des revendications précédentes, dans lequel le polymère comprend une troisième unité de répétition comprenant un groupe caractéristique de transport d'électrons,
et dans lequel, de préférence, le polymère comprend une quatrième unité de répétition différente comprenant un groupe caractéristique de transport de trous.

12. Polymère électroluminescent selon l'une quelconque des revendications précédentes, dans lequel le polymère comprend un copolymère à blocs, un copolymère régulier ou alterné ou un copolymère aléatoire.

13. Polymère électroluminescent selon l'une quelconque des revendications précédentes, comprenant de plus une ou plusieurs unités de répétition à émission dans le rouge et/ou le vert,
dans lequel les unités de répétition à émission dans le rouge et/ou dans le vert comprennent de préférence des émetteurs phosphorescents.

14. Polymère électroluminescent selon l'une quelconque des revendications précédentes, dans lequel les premières unités de répétition comprennent environ de 2 à 50 % en mole du polymère, exemple : de 10 à 35 % en mole ou de 20 à 30 % en mole du polymère.

15. Polymère électroluminescent selon l'une quelconque des revendications précédentes, dans lequel au moins une partie des premières unités de répétition fait office de groupe caractéristique d'émission de bleu.

16. Polymère électroluminescent selon l'une quelconque des revendications précédentes, dans lequel au moins une partie des premières unités de répétition fait office de groupe caractéristique de transport d'électrons.

17. Polymère électroluminescent selon l'une quelconque des revendications précédentes, dans lequel au moins une partie des premières unités de répétition fait office d'hôte triplet à forte énergie en présence d'un ou plusieurs émetteurs phosphorescents, par exemple si le polymère comprend un ou plusieurs émetteurs phosphorescents.

18. Polymère électroluminescent selon l'une ou plusieurs des revendications précédentes, dans lequel les premières unités de répétition et les secondes unités de répétition sont sélectionnées de telle manière à ce qu'elles permettent un transfert de charge entre elles dans l'état excité.

19. Polymère électroluminescent selon l'une quelconque des revendications précédentes, dans lequel le polymère est capable d'émettre de la lumière proche du point blanc (x,y = 0,33, 0,33).

20. Dispositif optique comprenant un polymère selon l'une quelconque des revendications précédentes, ledit dispositif optique comprenant, de préférence, un émetteur phosphorescent de rouge et/ou de vert.
